# EUROPÄISCHE PATENTSCHRIFT

(11) **EP 1 410 416 B1**
(45) Veröffentlichungstag und Bekanntmachung des Hinweises auf die Patenterteilung: **14.12.2005**
(21) Anmeldenummer: 02754429.5
(22) Anmeldetag: 24.07.2002
(51) Int. Cl.: H01J 37/10

(54) **SCHLITZLINSENANORDNUNG FUR TEILCHENSTRAHLEN**
SLIT LENS ARRANGEMENT FOR PARTICLE BEAMS
SYSTEME DE LENTILLES A FENTES POUR FAISCEAUX DE PARTICULES

(30) Priorität: 25.07.2001 DE 10136190
(43) Veröffentlichungstag der Anmeldung: 21.04.2004
(73) Patentinhaber: Ceos Corrected Electron Optical Systems GmbH, 69126 Heidelberg (DE); Carl Zeiss SMT AG, 73447 Oberkochen (DE)
(72) Erfinder: MÜLLER, Heiko, 69126 Heidelberg (DE)
(74) Vertreter: Pöhner, Wilfried Anton, Dr.
(86) Internationale Anmeldenummer: PCT/DE2002/002722
(87) Internationale Veröffentlichungsnummer: WO 2003/015121

(56) Entgegenhaltungen:
- EP-A- 0 967 630
- WO-A-98/09313
- DE-A- 2 221 122
- DE-A- 19 944 857
- US-A- 5 831 270
- US-A- 6 064 071

## Beschreibung

Die Erfindung betrifft eine Schlitzlinsenanordnung für Teilchenstrahlen, insbesondere zur Projektion einer Maske auf ein Werkstück, mit einer kombinierten Linse, welche aus einer Zylinderlinse und einer Quadrupollinse besteht, deren optische Achsen parallel zueinander verlaufen, wobei die optische Achse der Quadrupollinse durch Änderung der elektrischen Erregung parallelverschiebbar ist, die Zylinderlinse und die Quadrupollinse zwischen den Polschuhen bzw. in den Elektroden jeweils eine spaltförmige Öffnung mit untereinander gleicher räumlicher Orientierung aufweisen, und die zu einander so ausgerichtet sind, daß die Fokussierung der Quadrupollinse in dem Schnitt erfolgt, in welchem die Zylinderlinse ohne Fokussierung ist, und die Defokussierung der Quadrupollinse in dem Schnitt erfolgt, in welchem die Zylinderlinse fokussiert.

Bei der Herstellung mikroskopisch feiner Strukturen werden optische und elektronenoptische Lithographieverfahren eingesetzt. Dabei bietet letzteres Verfahren aufgrund der wesentlich kleineren Wellenlänge der Elektronen den Vorteil einer erhöhten Auflösung. Dies bedeutet, daß der Abstand nahe beieinander liegender Punkte eines Objekts beim elektronen-optischen Verfahren kleinere Werte annehmen kann, bevor die beiden Punkte in der Bildebene der abbildenden Anordnung nicht mehr als einzelne Punkte trennbar sind. Bei der Herstellung von elektronischen Bauelementen und integrierten Schaltkreisen auf der Oberfläche von scheibenförmigen Halbleiterkristallen (Wafern) spielen elektronenoptische Lithographieverfahren daher eine wichtige Rolle.

Für die Elektronenprojektionslithographie werden kurzbrennweitige Elektronenlinsen benötigt, die einen möglichst großen Bereich der Maske auf den Wafer abbilden.

Nach dem Stand der Technik sind elektronenoptische Rundlinsensysteme bekannt, bei denen die optische Achse durch Überlagerungen eines Korrekturfeldes zum Rundlinsenfeld in Richtungen senkrecht zur optischen Achse parallelverschiebbar ist. Dabei bestimmt die Position der optischen Achse die Lage des Schreibfleckes auf dem Wafer. Bei einer dynamischen Überlagerung des Korrekturfeldes läßt sich mit dieser Anordnung daher ein flächiger Wafer beschreiben. Als Nachteil dieser Systeme hat sich erwiesen, daß der Durchmesser des zu beschreibenden Bereichs sehr viel kleiner als der Bohrungsradius der Linsenpolschuhe ist. Dies hat zur Folge, daß zum Beschreiben von Werkstücken mit ausgedehnten Maßen, wie beispielsweise einem Wafer, die vorliegende Anordnung mit einen Schlitten zur Aufnahme des Werkstücks ausgestattet werden muß, der senkrecht zur optischen Achse in zwei Koordinatenrichtungen verschiebbar ist. Der zweidimensional verfahrbare Schlitten mit der geforderten hohen Präzision ist jedoch einerseits konstruktiv sehr aufwändig und dementsprechend teuer in der Herstellung. Er begrenzt andererseits durch die vergleichsweise geringe Verschiebegeschwindigkeit bzw. die zusätzliche Prüfung der Positionierung die Leistungsfähigkeit der Vorrichtung.

Daneben sind auch zwei Vorrichtungen unterschiedlicher Bauart zur Elektronenstrahllithographie bekannt geworden, bei denen elektronen-optische Elemente mit unrunden Feldern eingesetzt werden.

Die erste Vorrichtung dieser Art ist in der DE 196 34 456 offenbart. Sie weist eine elektrostatische Zylinderlinse und einen magnetischen Quadrupol auf, die in Kombination wie eine Rundlinse stigmatisch abbilden. Dem Quadrupol ist ein magnetisches Dipolfeld überlagerbar, das eine Verschiebung der optischen Achse in Richtung der Längsausdehnung des Zylinderlinsenspaltes bewirkt, wobei die Position der optischen Achse wiederum die Lage des Schreibfleckes auf dem Wafer bestimmt. Die genannte kombinierte Linse behält ihre Abbildungseigenschaften beim Verschieben der optischen Achse über nahezu die ganze Länge des Zylinderlinsenspaltes bei. Dementsprechend sind bei vorliegendem unrundem System gegenüber der vorbenannten Rundlinse wesentlich größere Bereiche des Wafers ohne dessen mechanischer Verschiebung beschreibbar. Der Nachteil der vorliegenden Vorrichtung ist darin zu sehen, daß der Wafer durch den fokussierten Elektronenstrahl punktweise beschrieben werden muß und daher die parallele Projektion eines ausgedehnten Maskenbereichs, wie bei der Elektronenprojektionslithographie üblich, nicht möglich ist.

Die zweite Vorrichtung der genannten Art ist in DE 196 44 857 offenbart. Sie umfaßt eine aus wenigsten drei Elektroden bestehende elektrostatische Zylinderlinse, deren mittlere Elektrode in Längsrichtung der spaltförmigen Elektrodenöffnung aus elektrisch von einander isolierten Segmenten besteht (Kammelektrode). Aufgrund dieses Aufbaus können die einzelnen Segmente der Mittelelektrode mit unterschiedlichen Potentialen belegt werden. Bei vorliegender Vorrichtung ist die Potentialverteilung so gewählt, daß ein elektrostatischer Quadrupol erzeugt wird. Wie die vorbenannte Vorrichtung weist somit auch die vorliegende Anordnung eine mit einer Quadrupollinse kombinierte Zylinderlinse auf, jedoch mit dem Unterschied, daß der Quadrupol elektrischer Natur ist. Die Abbildungseigenschaften des vorliegenden Linsensystems entspricht in nachteiliger Weise weitgehend denen des vorbenannten.

Vor diesem Hintergrund hat sich die Erfindung die Aufgabe gestellt, eine Schlitzlinsenanordnung für die Elektronenprojektionslithographie anzugeben, bei welcher das auf dem Wafer erzeugte Bild der Maske ein um ein Vielfaches größeres Bildfeld um die optische Achse umfaßt, die Herstellung von Wafern somit wesentlich vereinfacht und beschleunigt wird.

Diese Aufgabe läßt sich erfindungsgemäß durch zwei unterschiedliche Schlitzlinsenanordnungen lösen.
- wenigstens zwei kombinierte Linsen hintereinander mit jeweils funktionell gleichen Elementen vorgesehen sind,
   - wobei die optische Achsen der kombinierten Linsen relativ zueinander verschiebbar sind,
   - die Durchstoßpunkte der Achsen durch Objekt- und Bildebene die Zentren des Objekt- und Bildfelders festlegen, die aufeinander abgebildet werden,
   - und die Doppelablenkung der optischen Achse durch das induzierte Dipolfeld der verschobenen Quadrupollisen erfolgt,
- der Strahlengang durch das Gesamtsystem näherungsweise teleskopisch ist,
- die Beugungsebene (Aperturebene) des Gesamtsystems zwischen beiden kombinierten Linsen liegt
   und auf der Mittelachse einen Punkt festlegt, bezüglich dessen
   - die kombinierten Linsen derart angeordnet sind, daß sie antisymmetrisch zu einander liegen und gleichzeitig die Bedingung erfüllen, daß
      - der Abstand der ersten und der zweiten kombinierten Linse von der Beugungsebene (Aperturebene) und der Aufbau und /oder die Felder funktionell gleicher Elemente der kombinierten Linsen
         zueinander jeweils im Verhältnis stehen, das näherungsweise dem Abbildungsmaßstab, vorzugsweise Verkleinerungsmaßstab, entspricht,
- die Verschiebungen der optischen Achse der Quadrupollinse beider kombinierter Linsen in diametral entgegengesetzte Richtungen erfolgen,
   - wobei die Größe der Verschiebungen zueinander jeweils im Verhältnis stehen, das dem Abbildungsmaßstab, vorzugsweise Verkleinerungsmaßstab, entspricht.

Die erste Schlitzlinsenanordnung gemäß vorliegender Erfindung baut auf einer an sich bekannten, im Stand der Technik beschriebenen kombinierten Linse auf, die aus einer elektrostatischen Zylinderlinse und einer magnetischen oder elektrostatischen Quadrupollinse besteht. Dabei ist die optische Achse der Quadrupollinse parallel zu sich selbst verschiebbar ausgebildet. Die Mittel zur Verschiebung der optischen Achse umfassen je nach Ausbildung des Quadrupols elektrostatische oder magnetische Felder.

Bei vorliegender Erfindung sind zwei kombinierte Linsen mit funktionell gleichen Elementen vorgesehen, deren optische Achsen koaxial zueinander liegen und die Mittelachse des Gesamtsystems definieren. Die Linsen sind so angeordnet, daß der Strahlengang durch das Gesamtsystem teleskopisch ist. Die Beugungsebene des Gesamtsystems kommt dabei zwischen beiden kombinierten Linsen zu liegen und legt auf der Mittelachse einen Symmetriepunkt fest. Bezüglich dieses Punktes sind die kombinierten Linsen derart angeordnet,
- daß sie antisymmetrisch zu einander liegen und gleichzeitig die Bedingung erfüllen, daß
- der Abstand der ersten und der zweiten kombinierten Linse von der Beugungsebene (Aperturebene)
- und der Aufbau
- und /oder die Felder funktionell gleicher Elemente der kombinierten Linsen
zueinander jeweils im Verhältnis stehen, das dem Abbildungsmaßstab, vorzugsweise Verkleinerungsmaßstab, entspricht.

Einem weiteren Merkmal vorliegender Erfindung entsprechend ist die optische Achse jeder der Quadrupollinsen der kombinierten Linsen parallelverschiebbar. Die Verschiebung wird durch Überlagern von, in der Regel zeitabhängigen, Dipolfeldern über die Quadrupolfelder der Quadrupollinsen erzeugt. Dabei werden die Dipolfelder in der Regel so vorgegeben, daß eine Verschiebung der optischen Achse der Quadrupollinse innerhalb der Mittelebene der Zylinderlinse resultiert. Erfindungswesentlich hierbei ist, daß die Verschiebung in beiden Quadrupollinsen in diametral entgegengesetzte Richtungen erfolgt, und die Größe der Verschiebungen zueinander jeweils im Verhältnis stehen, das dem Abbildungsmaßstab entspricht.

Diese Ausgestaltung der Schlitzlinsenanordnung führt dazu, daß die optischen Achsen der Quadrupollinsen in einem weiten Bereich verschiebbar sind. Bei Verschiebung in Längsrichtung der zwischen den Polschuhen bzw. in den Elektroden der kombinierten Linsen ausgebildeten spaltförmigen Öffnungen liegt die Größenordnung der Verschiebung im Bereich etlicher Zentimeter. Von entscheidender Bedeutung hierbei ist, daß die stigmatischen Abbildungseigenschaften des Gesamtsystems bei der Verschiebung erhalten bleiben. Die Erfindung ermöglicht den Projektionsbereich um den Faktor 8-10 gegenüber herkömmlichen Elektronenprojektionslithographiesystemen, die auf Rundlinsen mit überlagerten Korrekturelementen basieren.

Ein Kerngedanke der Erfindung besteht darin, das Gesamtsystem aus zwei Linsensystemen mit funktionell gleichen Elementen zusammenzusetzen und derart hintereinander anzuordnen, daß sie - unter Berücksichtigung des Verkleinerungsmaßstabs - antisymmetrisch zu einander liegen. Diese Anordnung führt dazu, daß bei Durchstrahlung des Gesamtsystems die funktionell gleichen Elemente der zweiten kombinierten Linse in umgekehrter Reihenfolge wie die der ersten durchlaufen werden und als Folge hiervon in den einzelnen kombinierten Linsen vorhandene Abbildungsfehler für das Gesamtsystem verschwinden. Im vorliegenden Fall handelt es sich um die Verzeichnung, wobei sowohl der isotrope als auch anisotrope Anteil verschwinden, und insbesondere den außeraxialen Farbfehler.

Die vorteilhafte Folge der Elimination dieser Bildfehler ist ein vergleichsweise großes nutzbares Bildfeld, d. h. ein großer Bereich um die optische Achse, der sich auf dem Werkstück scharf abbildet. Bezogen auf die Gegenstandsebene bedeutet dies, daß eine Maske in vergleichsweise großen, dem Bildfeld entsprechenden Ausschnitten erfaßt wird und daher durch weiträumiges Scannen vollständig auf das Werkstück abbildbar ist. Damit lassen sich die Zeiten zur Übertragung der Maske wesentlich verkürzen, die Herstellung von beispielsweise Wafern läßt sich somit wesentlich vereinfachen.

Gemäß einem Merkmal der Erfindung ist vorgesehen, daß die vorliegende Schlitzlinsenanordnung in der Elektronen- oder lonenprojektionslithograpie eingesetzt und insbesondere zur Herstellung von Wafern verwendet wird. In einer solchen Vorrichtung dient die erfindungsgemäße Schlitzlinsenanordnung dazu, eine Maske auf ein Werkstück, speziell einen Wafer, zu projizieren. Die Beschreibung des Werkstücks erfolgt in der Regel dabei so, daß die der Abbildung zugrunde liegende optische Achse und mit ihr der scharf abgebildete Bereich des Bildfeldes über das Werkstück geführt wird. Dabei wird die im Bildfeld wiedergegebene Struktur der Maske auf das Werkstück übertragen. Die Übertragung des verschiebbaren Bildfeldes erfolgt also parallel. Für diesen Vorgang ist es zweckmäßig, wenn die Verschiebung der optischen Achse in Längsrichtung oder nahezu in Längsrichtung der zwischen den Polschuhen bzw. in den Elektroden der kombinierten Linsen ausgebildeten spaltförmigen Öffnungen erfolgt. Hierdurch ist sichergestellt, daß bei der Verschiebung der maximal mögliche Verschiebeweg ausgenutzt wird.

Bei einem Ablenkzyklus der genannten optischen Achse wird auf dem Werkstück ein Streifen beschrieben, dessen Länge etwa der Länge der spaltförmigen Öffnungen in den kombinierten Linsen entspricht und dessen Breite durch den Durchmesser des übertragenen Bildfeldes gegeben ist. Dabei ist von Vorteil, daß beide Parameter bei der Schlitzlinsenanordnung gemäß vorliegender Erfindung sehr viel größere Werte als bei Schlitzlinsenanordnungen nach dem Stand der Technik annehmen.

Um die ganze Maske auf das Werkstück zu übertragen ist es notwendig, Maske und Werkstück verschiebbar auszubilden und den Ablenkzyklus wiederholt durchzuführen. Dabei setzt der Schreibstrahl am ursprünglichen Rand des Werkstücks, um einen gewissen Betrag in Bewegungsrichtung des Werkstücks versetzt, wieder auf und beschreibt einen neuen Streifen auf dem Werkstück. Um sicherzustellen, daß jeder neue Streifen lückenlos an den vorhergehenden anschließt, ist es notwendig Vorschubgeschwindigkeit und Ablenkgeschwindigkeit geeignet auf einander abzustimmen. Gemäß einem Merkmal der Erfindung ist daher vorgesehen, daß
- die Verschiebung des Werkstücks senkrecht zur Längsachse der spaltförmigen Öffnungen erfolgt und mit konstanter Geschwindigkeit v₁ durchgeführt wird,
- die Verschiebung der optischen Achsen der genannten Quadrupollinsen aus einer Hin- und einer Rückbewegung besteht,
- wobei während der Hinbewegung das auf das Werkstück abgebildete Bildfeld mit konstanter Geschwindigkeit v₂ über das Werkstück läuft
- und für das Verhältnis der Geschwindigkeiten die Beziehung gilt v₁ / v₂ etwa gleich d / b,
wobei d dem Durchmesser des Bildfeldes entspricht und b die Breite des Werkstücks quer zu dessen Verschieberichtung angibt.

Die Einhaltung der angegebenen Beziehung führt zu der gewünschten lükkenlosen Beschreibung des Werkstücks.

Vorschub des Werkstücks und Ablenkung der optischen Achse führen dazu, daß die auf dem Werkstück beschriebenen Streifen von der Senkrechten zur Vorschubrichtung um einen kleinen Winkel abweichen. Will man diese "schrägen" Streifen auf dem Werkstück vermeiden, müssen alternativ die Richtung von Vorschub oder Ablenkung so gewählt werden, daß die Verschiebung der optischen Achsen der genannten Quadrupollinsen von der Längsrichtung der spaltförmigen Öffnungen bzw. die Verschiebung des Werkstücks von der Senkrechten zur Längsrichtung der spaltförmigen Öffnungen jeweils um einen entsprechenden kleinen Winkel abweichen. Die Erfindung sieht entsprechende Ausführungsformen vor, die insbesondere dann mit Vorteil einzusetzen sind, wenn auf den Wafer Strukturen geschrieben werden sollen, die rechtwinklig zur Vorschubrichtung verlaufen.

Die folgenden Weiterbildungen der Erfindung betreffen vorteilhafte konstruktive Maßnahmen für die vorgeschlagene Schlitzlinsenanordnung.

Bei einer bevorzugten Ausführungsform der Schlitzlinsenanordnung ist vorgesehen, die genannten Zylinderlinsen als elektrostatische Linsen und die genannten Quadrupollinsen wahlweise als elektrostatische oder magnetische Linsen auszubilden. Diese Ausgestaltung ermöglicht eine vergleichsweise einfache Berechnung der Bildfehler der Schlitzlinsenanordnung. Für eine Optimierung der Abbildungseigenschaften und insbesondere der Bildfeldgröße ist die Kenntnis der Bildfehler unerläßlich. Die Festlegung auf elektrostatische Zylinderlinsen vermeidet insbesondere die bei magnetischen Zylinderlinsen durch die Lamordrehung auftretenden Schwierigkeiten bei einer analytischen Berechnung.

Bei der Variante der Schlitzlinsenanordnung mit magnetischen Quadrupolen ist es von Vorteil, wenn das Quadrupolfeld von einer rechteckigen Öffnung in einem Werkstoff hoher magnetischer Permeabilität erzeugbar ist, an deren Rändern stromdurchflossene Leiter parallel zur optischen Achse der kombinierten Linse verlaufen. Dabei ist der Stromfluß in den Leitern auf gegenüberliegenden Rändern der Öffnung parallel und auf den dazu senkrechten Rändern entgegen gerichtet. Vorzugsweise ist die Summe aller Ströme durch die Öffnung gleich Null, um geschlossen umlaufende Megnetfeldlinien zu vermeiden. Bei der technischen Umsetzung dieser Anordnung werden die Leiter zweckmäßig durch eine auf ein Joch gewickelte Spule gebildet, die im Inneren der Öffnung angebracht ist, so daß die Leiter parallel zu optischen Achse orientiert sind.

Bei vorbenanntem Quadrupol läßt sich die Verschiebung der optischen Achse mit Vorteil durch Überlagerung eines magnetischen Dipols erreichen. Ein Dipolfeld parallel zur Längsachse der spaltförmigen Öffnungen in den Elektroden der Zylinderlinsen bewirkt dabei eine Verschiebung der optischen Achse des Quadrupols in eben dieser Richtung. Technisch wird der Dipol am einfachsten durch zwei beabstandete Joche aus einem magnetisch leitenden Material hergestellt, die mit je einer Spule umwickelt sind. Die Erzeugung des Dipolfeldes durch elektrische Ströme ermöglicht die gezielte Wahl der Dipolstärke durch entsprechende Vorgabe des Erregerstroms. Zusätzlich ist es möglich, dem Quadrupolfeld zwei zueinander und zur optischen Achse orthogonale Dipolfelder zu überlagern, um eine beliebige Verschiebung der optischen Achse über die Fläche der rechteckigen Öffnung zu erreichen.

Bei der zweiten Variante der Schlitzlinsenanordnungen mit elektrostatischen Quadrupolen ist vorgesehen, daß wenigstens jeweils eine Elektrode der Zylinderlinsen, vorzugsweise jeweils die innere, in Längsrichtung der spaltförmigen Öffnung aus elektrisch von einander isolierten Segmenten besteht (Kammelektrode), und die Segmente mit unterschiedlichen Potentialen beaufschlagbar sind. Diese Ausgestaltung führt zu einer diskreten Translationssymmetrie der Linse in Richtung von deren spaltförmiger Öffnung. Durch geeignete Potentiale an den einzelnen Segmenten der Elektrode lassen sich sowohl Multipolfelder als auch zeitlich über die Eiektrode wandernde Felder realisieren.

Von besonderem Interesse ist dabei, gemäß einem Merkmal der Erfindung, die Beaufschlagung der Segmente mit Potentialen, die zur Entstehung eines Quadrupolfeldes führen. Die Zylinderlinse und die so erzeugte Quadrupollinse zusammen weisen die gleichen Abbildungseigenschaften auf, wie das elektrisch/magnetische Pendant im vorangehenden Teil der Beschreibung.

Gemäß einem Merkmal der Erfindung sind die Potentiale auf den einzelnen Segmenten zeitabhängig und wandern sukzessiv von einem zum nächsten Segment. Hierdurch verschieben sich die Quadrupolfelder synchron zum Potential über die Länge der spaltförmigen Öffnung und mit ihnen die der Abbildung zugrunde liegende optische Achse. Gegenüber der vorhergehenden Schlitzlinsenanordnung mit gemischten Feldarten bietet die vorliegende Ausführungsform den Vorteil, daß die Ablenkung der optischen Achse und damit die Bewegung des Schreibstrahls mit einer vergleichsweise hohen Geschwindigkeit durchgeführt werden können, da das System frei von magnetischer Trägheit ist.

Bei dem vorliegenden unrunden System weist das abbildende Strahlenbündel in Abhängigkeit vom geometrischen Ort auf der Mittelachse des Systems im allgemeinen auch einen unrunden Querschitt auf. Insbesondere in der Aperturebene liegen in beiden zu einander senkrechten Schnitten unterschiedliche Aperturwinkel vor. Wie dem Fachmann bekannt, werden durch Blenden in dieser Ebene die aperturabhängigen Bildfehler reduziert. Es wird daher vorgeschlagen, zur Bildfehlerbegrenzung bei vorliegender Schlitzlinsenanordnung unrunde Blenden in der Beugungsebene (Aperturebene), vorzugsweise solche mit elliptischer oder rechteckiger Form, vorzusehen. Eine Blende dieser Art führt dazu, daß die Bildfehler in der Ebene des Werkstücke in etwa richtungsunabhängig vermindert werden und bei vorgegebener Auflösung eine maximale Transmission erreicht werden kann. Denkbar ist auch die Verwendung von runden Aperturblenden, die dazu führen, daß die Apertur in einem Schnitt mehr beschnitten wird als im dazu senkrechten. Demzufolge ist die Bildfehlerbegrenzung in beiden Schnitten unterschiedlich ausgebildet.

Von grundsätzlicher Bedeutung für hochauflösende elektronenoptische Linsensysteme ist die Energiebreite der Elektronen innerhalb des Elektronenstrahls. Dabei ist die Auflösung um so besser, je kleiner die Energiebreite und der mit ihr einhergehende (axiale) Farbfehler ist.

Bei einem elektronenoptischen Systemen, dessen Strahlengang - wie die vorliegende Schlitzlinsenanordnung - Punkte (außerhalb der Ebene des Werkstücks) aufweist, in welchen die Elektronen fokussiert werden, hängt die Energiebreite der Elektronen unter anderem auch von der stochastischen Strahlwechselwirkung ab. Darunter versteht man das Phänomen, daß die Elektronen beim Durchgang durch die genannten Punkte aufgrund der in diesem Bereich herrschenden hohen Stromdichten einer Streuung unterliegen, die zu einer Verschlechterung der erreichbaren optischen Auflösung. Zur Vermeidung dieses Nachteils wird bei der erfindungsgemäßen Schlitzlinsenanordnung vorgeschlagen, im Bereich der Aperturblendenebene eine Elektrode vorzusehen und diese mit einem hohen Potential zu beaufschlagen. Das Potential ist dabei so zu wählen, daß die Energie der Elektronen im Bereiche der Aperturblendenebene größer ist als in der Maskenebene und der Werkstückebene. Man erreicht in vorteilhafter Weise hierdurch eine Verringerung des Streueffektes.

Ein möglicher Nachteil der Ausführungsform der vorgeschlagenen Schlitzlinsenanordnung mit rein elektrostatischen Linsen könnte sein, daß bei den üblicherweise hohen Strahlspannungen Durchbruchprobleme an den Elektroden der Linsen auftreten. Eine mögliche Abhilfe für dieses Problem besteht in der Reduktion der Energie der Elektronen, was anderseits wiederum zu einer Zunahme des Farbfehlers und damit zu einer Verringerung der optischen Auflösung führen würde. Diese Lösung ist daher nur akzeptabel, wenn der Farbfehler durch andere Maßnahmen reduziert wird. Erfindungsgemäß wird diesem möglichen Problem bei vorliegender Schlitzlinsenanordnung dadurch begegnet, daß die verwendeten Masken als freitragende Struktur ausgebildet werden können. Bei den heute eingesetzten Masken sind die auf das Werkstück abzubildenden Strukturen üblicherweise auf eine Folie aufgebracht. Bei Einsatz von Masken dieser Art in der Elektronenstrahl-Lithographie führt die inelastische Streuung von Elektronen an der Folie jedoch zu einer Energieverbreiterung der Elektronen und somit zu einer Zunahme des Farbfehlers. Durch Wegfall der Trägerfolien wird die hierdurch bedingte Energieverbreiterung somit eliminiert.

Weiterbildungen der Erfindung sehen zusätzliche Multipolfelder im Strahlengang vorliegender Schlitzlinsenanordnung vor. Diese Felder dienen der effektiveren Korrektur möglicher Bildfehler und führen dementsprechend zu einer weiteren Vergrößerung des Bildfeldes.

Bevorzugt wird hierbei eine Ausführungsform, bei der weitere Elektroden der Zylinderlinsen und/oder Elektroden zusätzlicher Zylinderlinsen als Kammelektrode ausgebildet sind, d.h. in Längsrichtung der spaltförmigen Elektrodenöffnung elektrisch voneinander isolierte Segmente aufweisen, die mit unterschiedlichen Potentialen beaufschlagbar sind.

Eine besonders bevorzugte Ausgestaltung sieht vor, auf den weiteren Elektroden Potentiale anzulegen, die zur Entstehung von zusätzlichen Quadrupolfeldern führen. Dabei werden die Potentiale vorzugsweise zeitabhängig vorgegeben, so daß die zusätzlichen Quadrupolfelder synchron zu den bereits vorhanden beiden Quadrupolfeldern über die volle Länge der spaltförmigen Öffnungen bewegt werden. Diese zusätzliche Quadrupolfelder werden mit Vorteil zur Korrektur von Bildfehlern genutzt, die ihren Ursprung in der von der Mittelachse abweichenden Position des Bildfeldes haben.

Bei der Variante der Schlitzlinsenanordnung gemäß vorliegender Erfindung mit zwei kombinierten Linsen, die jeweils aus zwei elektrostatischen Zylinderlinsen und je einem integrierten magnetischen Quadrupol bestehen, führt die Segmentierung der weiteren Elektroden insgesamt zu einer Anordnung mit vier Kammelektroden und zwei unsegmentierten Elektroden. Die vier Kammelektroden werden zur Erzeugung von weiteren elektrostatischen, die zwei unsegmentierten Elektroden, wie bereits dargelegt, zur Erzeugung der magnetischen Quadrupole genutzt. Dabei dienen die magnetischen Quadrupole in Zusammenwirkung mit den magnetischen Dipolen zur (zeitabhängigen) Lateralverschiebung der optischen Achse, während die weiteren elektrostatischen Quadrupole, wie erwähnt, der Bildfehlerkorrektur dienen.

Des weiteren ist gemäß vorliegender Erfindung auch vorgesehen, den einzelnen Quadrupolfeldern Multipolfelder höherer Ordnung, vorzugsweise Hexapol- und Oktupolfelder, zu überlagern. Bevorzugt werden hierbei elektrostische Felder, die gegenüber magnetischen Feldern aufgrund der fehlenden magnetischen Trägheit, höhere Geschwindigkeit bei der Änderung der Feldstärken zulassen. Gemäß einem Merkmal der Erfindung sind auch diese höheren Multipolfelder parallel verschiebbar, so daß sie mit der Bewegung der optischen Achse mitgeführt werden können. Sie dienen ebenso wie die zusätzlichen Quadrupolfelder der effektiveren Korrektur der Bildfehler.

Bei einer Alternative zu der bisher dargestellten Lösung und deren weiteren Ausgestaltungen ist alternativ oder zusätzlich zu den magnetischen Quadrupolfeldern in den kombinierten Linsen ein aus zwei Einzelmagneten bestehender Ablenkmagnet mit statischem Feld vorgesehen. Diesem fällt die Aufgabe zu, die Ablenkung der optischen Achse der Abbildung zu bewirken. Bei dieser Lösung ist im einzelnen vorgesehen, daß
- zwischen der ersten und zweiten kombinierten Linse zwei Ablenkmagnete angebracht sind,
   - die zu einem Magneten gehörigen Polschuhe
      - jeweils gleiche Form aufweisen
      - und spiegelsymmetrisch zu der Ebene angeordnet sind, welche die in Längsrichtung der spaltförmigen Öffnungen weisenden Mittelebenen der Zylinderlinsen enthält,
   - die zeitlich konstanten Magnetfelder beider Magnete derart ausgebildet sind,
      daß parallel in das Magnetfeld des in Durchstrahlungsrichtung der Schlitzlinsenanordnung ersten Magnets eintretende Strahlen in dem auf der Beugungsebene liegenden Punkt der Mittelachse fokussiert werden und den zweiten Magneten wieder als parallele Strahlen verlassen,
      - wobei die Größe der Verschiebungen zueinander jeweils im Verhältnis stehen, das dem Abbildungsmaßstab, vorzugsweise Verkleinerungsmaßstab, entspricht.

Die Einbeziehung eines zweiteiligen Ablenkmagneten in vorliegende Schlitzlinsenanordnung führt dazu, daß die Mittelachse der Anordnung eine gekrümmte, in einer Ebene liegende Form annimmt. In dieser Ebene liegen auch die in Längsrichtung der spaltförmigen Öffnungen weisenden Mittelebenen der Zylinderlinsen. Die Polschuhe der beiden Ablenkmagnete sind zu dieser Ebene ebenfalls spiegelsymmetrisch ausgebildet, die Ebene stellt somit eine Symmetrieebene des Systems dar. Die Beugungsebene des Gesamtsystems liegt zwischen beiden Magneten.

Die Form der Polschuhe ist durch die Forderung bestimmt, daß ein Ablenkmagnet wie ein optisch abbildendes System wirken muß. Bei einem Einsatz des Ablenkmagneten als Ersatz für die magnetischen Ablenkfelder in den kombinierten Linsen werden daher parallel in das Magnetfeld des in Durchstrahlungsrichtung der Schlitzlinsenanordnung ersten Magnets eintretende Strahlen in den auf der Beugungsebene liegenden Punkt der Mittelachse fokussiert und verlassen den zweiten Magneten wieder als parallele Strahlen.

Für die vorbenannte Schlitzlinsenanordnung stellt die Ausführungsform mit dem Ablenkmagneten eine mögliche Alternative dar. Der vorgeschlagene Ablenkmagnet ist jedoch auch Grundlage für die zweite Lösung des erfindungsgemäßen Problems. Diese Lösung ist durch die im Anspruch 21 wiedergegebenen Merkmale gekennzeichnet.

Bei dieser Lösung sind die kombinierten Linsen jeweils durch eine Vierergruppe von verschiebbaren magnetischen Quadrupolen ersetzt worden. Das Gesamtsystem besteht demzufolge - bei Durchlaufen des Systems in Strahlrichtung - aus einer ersten Vierergruppe und einem ersten Ablenkmagneten vor der Beugungsebene und einem zweiten Ablenkmagneten und einer zweiten Vierergruppe hinter der Beugungsebene. In diesem Fall können verschiebbare Multipole durch zusätzliche Wicklungen auf den Spulenkörpern der Quadrupollinsen erzeugt und zur Korrektur von Bildfehlern vorteilhaft eingesetzt werden. Die grundsätzlichen optischen Eigenschaften dieser Schlitzlinsenanordnung entsprechen weitgehend denen der ersten erfindungsgemäßen Lösung.

Der Vorteil vorliegender Anordnung ist in der rein magnetischen Betriebsweise des Systems zu sehen. Sie ermöglicht hohe elektrische Beschleunigungsspannungen für die Elektronen und damit einhergehend niedrige Farbfehler und dementsprechend große Bildfelder der Anordnung. Mögliche Durchbruchprobleme an elektrostatischen Linsen sind a priori ausgeschlossen, da das System keine derartigen Linsen enthält.

Weitere Einzelheiten, Merkmale und Vorteile der Erfindung lassen sich dem nachfolgenden Teil der Beschreibung entnehmen. In diesem Teil werden zwei Ausführungsbeispiel der vorgeschlagenen Schlitzlinsenanordnung anhand einer schematischen Zeichnung näher erläutert.

Es zeigen:
- Figur 1:: eine Prinzipskizze einer Ausführungsform gemäß der ersten Lösung
- Figur 2:: eine Prinzipskizze einer Ausführungsform gemäß der zweiten Lösung

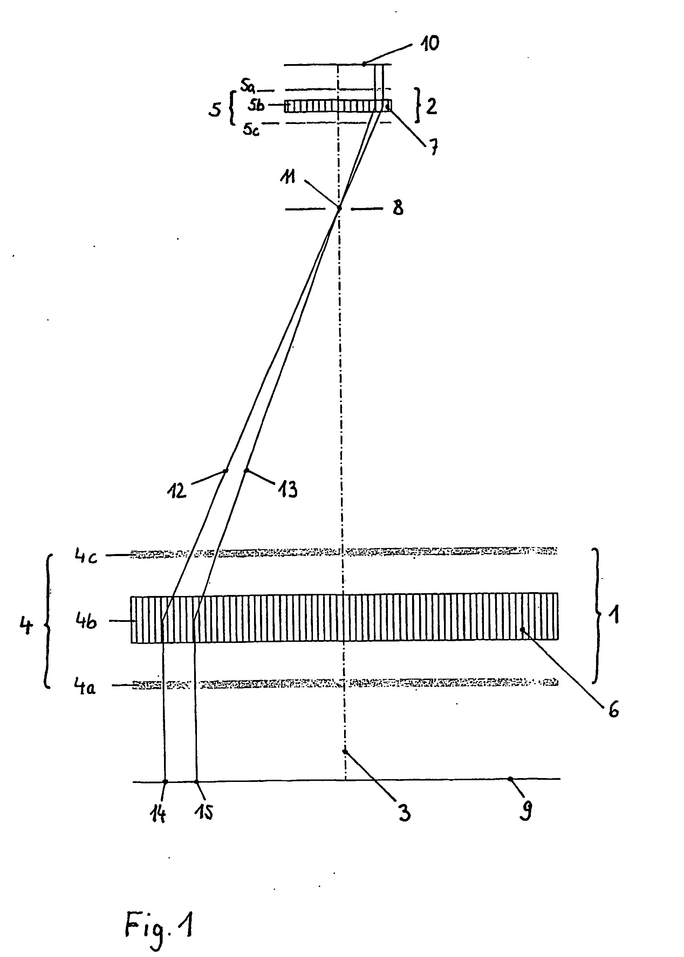

In Figur 1 sind die Komponenten und andeutungsweise der Strahlengang durch eine Anordnung wiedergegeben, die aus einer ersten 1 und einer zweiten kombinierten Linse 2 besteht, die kollinear zu einander entlang der Mittelachse 3 des Gesamtsystems angeordnet sind. Jede kombinierte Linse besteht aus einer elektrostatischen Zylinderlinse 4 bzw. 5 mit je drei Elektroden 4a, 4b, 4c bzw. 5a, 5b, 5c und einem auf der Mittelelektrode 4b bzw. 5b integrierten magnetischen Quadrupol 6 bzw. 7. Die spaltförmigen Öffnungen in den Elektroden der Zylinderlinsen sind so ausgerichtet daß ihrer Längsrichtung parallel zur Zeichenebene verläuft, wobei die Mittelebene der Spalte in der Zeichenebene liegt. Bei vorliegender Darstellung werden sie durch die Umrisse der Elektroden verdeckt.

Die äußeren Elektroden 4a, 4c bzw. 5a, 5c sind jeweils als Kammelektrode ausgebildet, d.h. sie sind in Richtung der Längsausdehnung der Spalte aus einzelnen von einander isolierten Segmenten aufgebaut, die jeweils für sich mit einem Potential beaufschlagbar sind. Dabei können die Potentiale so vorgegeben werden, daß sie zur Entstehung von Quadrupol-, Hexapol- oder auch Oktupolfeldern führen, die in Längsrichtung der Kammelektrode wandern. Felder dieser Art lasen sich mit Vorteil zur Korrektur von optischen Abbildungsfehlern verwenden.

Mit dem Bezugszeichen 8 ist die Lage der Beugungsebene angedeutet. Wie der Zeichnung zu entnehmen ist, liegt sie zwischen den kombinierten Linsen 1 und 2. Die Maske ist durch das Bezugszeichen 9 und das Werkstück durch das Zeichen 10 gekennzeichnet.

Bezüglich des Punktes 11, der sich als Schnittpunkt der Beugungsebene 8 mit der Mittelachse 3 ergibt, sind die kombinierten Linsen 1 und 2 derart angeordnet, daß sie antisymmetrisch zu einander liegen und gleichzeitig die Bedingung erfüllen, daß der Abstand der ersten und der zweiten kombinierten Linse von der Beugungsebene (Aperturebene), der Aufbau und die Felder funktionell gleicher Elemente der kombinierten Linsen zueinander jeweils im Verhältnis des Verkleinerungsmaßstabes stehen.

Unter 12 und 13 sind stellvertretend für einen kompletten Strahlengang zwei optische Achsen angegeben, die bei Abbildung der Maskenpunkte 14 bzw. 15 maßgeblich sind. Die optischen Achsen der Quadrupole 6, 7 sind bei vorliegender Schlitzlinsenanordnung parallelverschiebbar ausgebildet. Die Verschiebung der Quadrupolachsen wird durch (nicht eingezeichnete) magnetische Dipole erreicht, die jeweils am Ort der Quadrupole wirksam und in der Zeichenebene senkrecht zur Mittelachse 3 ausgerichtet sind.

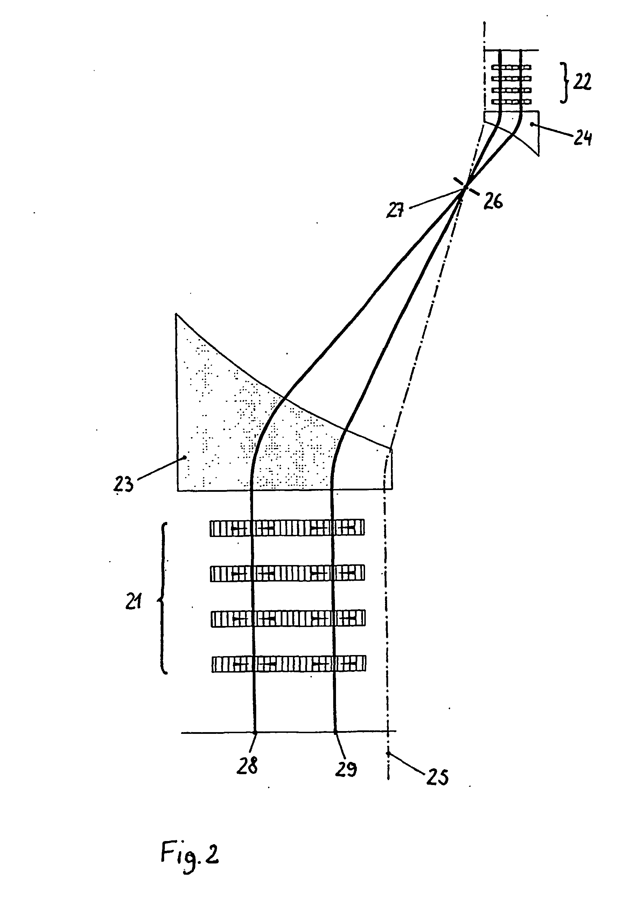

In Figur 2 ist in der gleichen Darstellungsart eine Schlitzlinsenanordnung wiedergegeben, die aus einer ersten 21 und einer zweiten Vierergruppe 22 von Quadrupolen und einem ersten 23 und zweiten Ablenkmagnet 24 besteht. Die Mittelachse 25 des Gesamtsystems nimmt bei dieser Ausführungsform eine gekrümmte, in der Zeichenebene liegende Form an. Die Polschuhe der beiden Magnete 23, 24 sind spiegelbildlich oberhalb und unterhalb der Zeichenebene angeordnet. Ihre Form ist so gestaltet, daß parallel in das Magnetfeld des ersten Magneten 23 eintretende Strahlen in den auf der Beugungsebene 26 liegenden Punkt 27 der Mittelachse 25 fokussiert werden und den zweiten Magneten 24 wieder als parallele Strahlen verlassen.

Bezüglich des Punktes 27 auf der Beugungsebene 26 des Gesamtsystems sind die genannten Vierergruppen 21, 22 und die Ablenkmagnete 23, 24 derart angeordnet sind, daß sie antisymmetrisch zu einander liegen und gleichzeitig die Bedingung erfüllen, daß der entlang der (gekrümmten) Mittelachse 25 des Gesamtsystems gemessene Abstand von funktionell gleichen Element der ersten und der zweiten Vierergruppe 21, 22 und des ersten und zweiten Ablenkmagneten 23, 24 von der Beugungsebene 26 und der Aufbau und /oder die Felder der Ablenkmagnete und der funktionell gleichen Elemente der Vierergruppen zueinander jeweils im Verhältnis stehen, das dem Abbildungsmaßstab entspricht.

Mit den Bezugszeichen 28, 29 sind zwei Lagen der optischen Achse wiedergegeben, die für die Abbildung von unterschiedlichen Maskenbereichen auf das Werkstück maßgebend sind.

Bei vorliegender Anordnung ist eine rein magnetische Betriebsweise gegeben, während das in Figur 1 dargelegte System mit elektrischen und magnetischen Feldern arbeitet. Beide Lösungen stellen ein großes nutzbares Bildfeld zu Verfügung bzw. ermöglichen die Abbildung eines großen Ausschnitts der Maske auf das Werkstück. Zur Übertragung der kompletten Maske ist daher nur ein weiträumiges Scannen erforderlich, wodurch die sich die Zeiten zur Herstellung von Wafern erheblich verkürzen läßt.

## Patentansprüche

1. Schlitzlinsenanordnung für Teilchenstrahlen, insbesondere zur Projektion einer Maske auf ein Werkstück,
- mit einer kombinierten Linse,
welche aus einer Zylinderlinse und einer Quadrupollinse besteht,
- deren optische Achsen parallel zueinander verlaufen,
- wobei die optische Achse der Quadrupollinse durch Änderung der elektrischen Erregung parallelverschiebbar ist,
- die zwischen den Polschuhen bzw. in den Elektroden jeweils eine spaltförmige Öffnung mit untereinander gleicher räumlicher Orientierung aufweisen,
- und die zu einander so ausgerichtet sind, daß
- die Fokussierung der Quadrupollinse in dem Schnitt erfolgt, in welchem die Zylinderlinse ohne Fokussierung ist,
- und die Defokussierung der Quadrupollinse in dem Schnitt erfolgt, in welchem die Zylinderlinse fokussiert,
**dadurch gekennzeichnet, daß**
- wenigstens zwei kombinierte Linsen (1, 2) hintereinander mit jeweils funktionell gleichen Elementen vorgesehen sind,
- wobei die optische Achsen der kombinierten Linsen (1, 2) relativ zueinander verschiebbar sind,
- die Durchstoßpunkte der Achsen durch Objekt- und Bildebene die Zentren des Objekt- und Bildfelders festlegen, die aufeinander abgebildet werden,
- und die Doppelablenkung der optischen Achse durch das induzierte Dipolfeld der verschobenen Quadrupollisen erfolgt,
- der Strahlengang durch das Gesamtsystem näherungsweise teleskopisch ist,
- die Beugungsebene (Aperturebene) (8) des Gesamtsystems zwischen beiden kombinierten Linsen (1, 2) liegt
und auf der Mittelachse einen Punkt (11) festlegt, bezüglich dessen
- die kombinierten Linsen (1, 2) derart angeordnet sind, daß sie antisymmetrisch zu einander liegen und gleichzeitig die Bedingung erfüllen, daß
- der Abstand der ersten und der zweiten kombinierten Linse von der Beugungsebene (Aperturebene) (8) und der Aufbau und /oder die Felder funktionell gleicher Elemente der kombinierten Linsen
zueinander jeweils im Verhältnis stehen, das näherungsweise dem Abbildungsmaßstab, vorzugsweise Verkleinerungsmaßstab, entspricht,
- die Verschiebungen der optischen Achse der Quadrupollinse (6, 7) beider kombinierter Linsen (1, 2) in diametral entgegengesetzte Richtungen erfolgen,
- wobei die Größe der Verschiebungen zueinander jeweils im Verhältnis stehen, das dem Abbildungsmaßstab, vorzugsweise Verkleinerungsmaßstab, entspricht.

2. Schlitzlinsenanordnung nach Anspruch 1, **dadurch gekennzeichnet, daß**
- die Verschiebung der optischen Achsen der genannten Quadrupollinsen (6, 7) in Richtung der Längsachse der spaltförmigen Öffnungen erfolgt.

3. Schlitzlinsenanordnung nach Anspruch 1 oder 2, **dadurch gekennzeichnet, daß**
- das Werkstück (10) senkrecht zur Mittelachse (3) des Gesamtsystems und senkrecht zur Längsachse der spaltförmigen Öffnungen verschiebbar ist,
- die Verschiebung des Werkstücks (10) mit konstanter Geschwindigkeit v₁ erfolgt,
- die Verschiebung der optischen Achsen der genannten Quadrupoiiinsen (6, 7) aus einer Hin- und einer Rückbewegung besteht,
- wobei während der Hinbewegung das auf dem Werkstück (10) abgebildete Bildfeld mit konstanter Geschwindigkeit v₂ über das Werkstück läuft
- und für das Verhältnis der Geschwindigkeiten die Beziehung gilt v₁ / v₂ etwa gleich d / b,
wobei d dem Durchmesser des Bildfeldes entspricht und b die Breite des Werkstücks (10) quer zu dessen Verschieberichtung angibt.

4. Schlitzlinsenanordnung nach einem der Ansprüche 1 - 3, **dadurch gekennzeichnet, daß**
- die Verschiebung der optischen Achsen der genannten Quadrupollinsen (6, 7) von der Längsrichtung der genannten spaltförmigen Öffnungen
- und/oder die Verschiebung des Werkstücks (10) von der Senkrechten zur Längsrichtung der genannten spaltförmigen Öffnungen, vorzugsweise um einen kleinen Winkel, abweicht.

5. Schlitzlinsenanordnung nach einem der Ansprüche 1 - 4, **dadurch gekennzeichnet, daß**
- die genannten Zylinderlinsen (4, 5) elektrostatische Linsen und die genannten Quadrupollinsen (6, 7) elektrostatische oder magnetische Linsen sind.

6. Schlitzlinsenanordnung nach Anspruch 5, **dadurch gekennzeichnet, daß**
- bei magnetischen Quadrupollinsen (6, 7) das Quadrupolfeld
von einer Öffnung in einem Werkstoff hoher magnetischer Permeabilität erzeugbar ist,
- an deren Rändern stromdurchflossene Leiter parallel zur optischen Achse der kombinierten Linse verlaufen,
- wobei der Stromfluß in den Leitern auf gegenüberliegenden Rändern der Öffnung parallel und auf den dazu senkrechten Rändern entgegen gerichtet ist.

7. Schlitzlinsenanordnung nach Anspruch 6, **dadurch gekennzeichnet, daß**
- dem Quadrupolfeld ein magnetisches Dipolfeld überlagerbar ist.

8. Schlitzlinsenanordnung nach Anspruch 5, **dadurch gekennzeichnet, daß**
- wenigstens jeweils eine Elektrode der genannten Zylinderlinsen, vorzugsweise jeweils die innere (4b, 5b), in Längsrichtung der spaltförmigen Öffnung aus elektrisch von einander isolierten Segmenten besteht (Kammelektrode),
- und die Segmente mit unterschiedlichen Potentialen beaufschlagbar sind.

9. Schlitzlinsenanordnung nach Anspruch 8, **dadurch gekennzeichnet, daß**
- durch Beaufschlagen der Segmente mit entsprechenden Potentialen eine elektrostatische Quadrupollinse erzeugbar ist.

10. Schlitzlinsenanordnung nach Anspruch 8 oder 9, **dadurch gekennzeichnet, daß**
- die Potentiale auf den einzelnen Segmenten zeitabhängig sind
- und sukzessiv von einem zum nächsten Segment wandern.

11. Schlitzlinsenanordnung nach einem der Ansprüche 1 - 10, **dadurch gekennzeichnet, daß**
- in der Beugungsebene (Aperturebene) (8) eine Blende mit vorzugsweise elliptischer oder rechteckiger Form vorgesehen ist.

12. Schlitzlinsenanordnung nach einem der Ansprüche 1 - 11, **dadurch gekennzeichnet, daß**
- im Bereich der Beugungsebene (Aperturebene) (8) eine Elektrode vorgesehen ist, die mit einem vergleichsweise hohen elektrischen Potential beaufschlagbar ist.

13. Schlitzlinsenanordnung nach einem der Ansprüche 1 - 12, **dadurch gekennzeichnet, daß**
- die genannten Masken (9) als freitragende Struktur ausgebildet sind.

14. Schlitzlinsenanordnung nach einem der Ansprüche 1 - 13, **dadurch gekennzeichnet, daß**
- weitere Elektroden der Zylinderlinsen und/oder Elektroden zusätzlicher Zylinderlinsen als Kammelektrode ausgebildet sind.

15. Schlitzlinsenanordnung nach Anspruch 14, **dadurch gekennzeichnet, daß**
- auf den genannten Elektroden, vorzugsweise zeitabhängige und pallelverschiebbare Quadrupolfelder erzeugbar sind.

16. Schlitzlinsenanordnung nach einem der Ansprüche 1 - 15, **dadurch gekennzeichnet, daß**
- den Quadrupolfeldern Multipolfelder höherer Ordnung, vorzugsweise Hexapol- und Oktupolfelder, überlagerbar sind

17. Schlitzlinsenanordnung nach Anspruch 16, **dadurch gekennzeichnet, daß**
- die höheren Multipolfelder elektrische Felder sind.

18. Schlitzlinsenanordnung nach einem der Ansprüche 16 - 17, **dadurch gekennzeichnet, daß**
- die optische Achse des Hexapolfeldes und des Oktupolfeldes parallelverschiebbar ist.

19. Verwendung der Schlitzlinsenanordnung nach einem der vorangehenden Ansprüche, **dadurch gekennzeichnet, daß**
- sie in der Elektronen- oder Ionenstrahl-Lithographie eingesetzt
- und insbesondere zur Herstellung von Wafern verwendet wird.

20. Schlitzlinsenanordnung für Teilchenstrahlen nach einem der vorangehenden Ansprüche, **dadurch gekennzeichnet, daß**
- zwischen der ersten und zweiten kombinierten Linse zwei Ablenkmagnete (23, 24) vorgesehen sind,
- die zu einem Magneten gehörigen Polschuhe
- jeweils gleiche Form aufweisen
- und spiegelsymmetrisch zu der Ebene angeordnet sind, welche die in Längsrichtung der spaltförmigen Öffnungen weisenden Mittelebenen der Zylinderlinsen enthält,
- die zeitlich konstanten Magnetfelder beider Magnete (23, 24) derart ausgebildet sind,
daß parallel in das Magnetfeld des in Durchstrahlungsrichtung der Schlitzlinsenanordnung ersten Magnets (23) eintretende Strahlen in dem auf der Beugungsebene liegenden Punkt (27) der Mittelachse (25) fokussiert werden und den zweiten Magneten (24) wieder als parallele Strahlen verlassen,
- wobei die optische Achse der Abbildung sich in beiden Ablenkmagneten in diametral entgegengesetzte Richtungen verschiebt,
- und die Größe der Verschiebungen zueinander jeweils im Verhältnis stehen, das dem Abbildungsmaßstab, vorzugsweise Verkleinerungsmaßstab, entspricht.

21. Schlitzlinsenanordnung für Teilchenstrahlen, insbesondere zur Projektion einer Maske auf ein Werkstück,
- mit einem Ablenkmagneten,
- und mehreren Quadrupollinsen,
**dadurch gekennzeichnet, daß**
- wenigstens zwei Ablenkmagnete (23, 24)
- und zwei Gruppen (21, 22) von Quadrupolen mit jeweils funktionell gleichen Elementen vorgesehen sind,
- die zu einem Magneten gehörigen Polschuhe jeweils gleiche Form aufweisen
- und spiegelsymmetrisch zu einer Ebene angeordnet sind,
- die genannten Ebenen beider Magnete (23, 24)
- komplanar zu einander liegen
- und die Mittelebene des Gesamtsystems definieren ,
- die optischen Achsen der genannten Quadrupollinsen in der genannten Mittelebene liegen und parallel zueinander ausgerichtet sind,
- die optischen Achsen der genannten Quadrupollinsen durch überlagerte Dipolfelder parallel verschiebbar sind,
- der Strahlengang durch das Gesamtsystem näherungsweise teleskopisch ist,
- die zeitlich konstanten Magnetfelder beider Magnete (23, 24) derart ausgebildet sind,
daß parallel in das Magnetfeld des in Durchstrahlungsrichtung der Schlitzlinsenanordnung ersten Magnets (23) eintretende Strahlen in einem Punkt (27) auf der Mittelebene des Gesamtsystems fokussiert werden und den zweiten Magneten (24) wieder als parallele Strahlen verlassen,
- die durch den genannten Punkt (27) gehende senkrecht zur Mittelebene stehenden Ebene die Beugungsebene (26) definiert,
- die genannten Quadrupollinsen (21, 22) und die Ablenkmagnete (23, 24) bezüglich des genannten Punktes (27) derart angeordnet sind, daß sie antisymmetrisch zu einander liegen und gleichzeitig die Bedingung erfüllen, daß
- der entlang der (gekrümmten) Mittelachse (25) des Gesamtsystems gemessene Abstand der funktionell gleichen Element der genannten ersten (21) und der zweiten (22) Vierergruppe und des ersten (23) und zweiten (24) Ablenkmagneten von der Beugungsebene (Aperturebene) (26) und der Aufbau und /oder die Felder der Ablenkmagnete und der funktionell gleichen Elemente der genannten Vierergruppen zueinander jeweils im Verhältnis stehen, das näherungsweise dem Abbildungsmaßstab, vorzugsweise Verkleinerungsmaßstab, entspricht,
- wobei die Größe der Verschiebungen zueinander jeweils im Verhältnis stehen, das dem Abbildungsmaßstab, vorzugsweise Verkleinerungsmaßstab, entspricht.

22. Schlitzlinsenanordnung für Teilchenstrahlen nach Anspruch 21, **dadurch gekennzeichnet, daß** die gesamten Gruppen (21, 22) von Quadrupolen aus jeweils vier Quadrupollinsen bestehen.

23. Schlitzlinsenanordnung für Teilchenstrahlen nach Anspruch 21, **dadurch gekennzeichnet, daß** die genannten Quadrupollinsen magnetisch sind.

## Claims

1. Slit lens arrangement for particle beams, in particular for projection of a mask onto a workpiece,
- comprising a combined lens, which consists of a cylinder lens and a quadrupole lens,
- the optical axes of which run parallel to one another
- the optical axis of the quadrupole lens being displaceable in a parallel manner,
- which have in each case a gap-shaped aperture between the pole shoes or in the electrodes with the same spatial orientation to one another,
- and are aligned with respect to one another, such that
- the focusing of the quadrupole lenses takes place in the section in which the cylinder lens is not focused,
- and the defocusing of the quadrupole lenses takes place in the section in which the cylinder lens focuses,
**characterised in that**
- at least two combined lenses (1, 2) are provided one behind the other with, in each case, functionally identical elements,
- the optical axes of the combined lenses (1, 2) being displaceable relative to one another,
- the penetration points of the axes through the object plane and image plane determining the centres of the object plane and image plane which are to be imaged one on the other,
- and the double deflection of the optical axis taking place by means of the induced dipole field of the displaced quadrupole lenses,
- the beam path through the entire system being approximately telescopic,
- the diffraction plane (aperture plane) (8) of the entire system lying between the two combined lenses (1, 2) and determining a point (11) on the centre axis, with respect to which
- the combined lenses (1,2) are arranged such that they lie antisymmetrically to one another and at the same time meet the condition that
- the distance of the first and second combined lenses from the diffraction plane (aperture plane) (8) and the construction and/or the fields of functionally identical elements of the combined lenses from one another are in each case in a ratio that corresponds to the imaging scale, preferably reduction scale,
- the displacements of the optical axis of the quadrupole lense (6, 7) of both combined lenses (1, 2) takes place in diametrically opposite directions,
- the magnitude of the displacements from one another being in a ratio that corresponds to the imaging scale, preferably the reduction scale.

2. Slit-lens arrangement according to claim 1, **characterised in that**
- the displacement of the optical axes of said quadrupole lenses (6, 7) takes place in the direction of the longitudinal axis of the gap-shaped apertures.

3. Slit-lens arrangement according to claim 1 or 2, **characterised in that**
- the workpiece (10) can be displaced perpendicular to the centre axis (3) of the entire system and perpendicular to the longitudinal axis of the gap-shaped apertures
- the displacement of the workpiece (10) takes place with a constant velocity v1,
- the displacement of the optical axes of the aforementioned quadrupole lenses (6, 7) consists of an advance movement and a return movement,
- the image field formed on the workpiece (10) travelling, during the advance movement, with constant velocity v2 over the workpiece
- and, for the ratio of the velocities, the following relationship applies: v1/v2 is approximately equal to d/b,
wherein d is the diameter of the image field and b is the width of the workpiece (10) transversely to its displacement direction.

4. Slit-lens arrangement according to one of claims 1-3, **characterised in that**
- the displacement of the optical axes of the aforementioned quadrupole lenses (6, 7) from the longitudinal direction of the aforementioned gap-shaped apertures,
- and/or the displacement of the workpiece (10) deviates, preferably by a small angle, from the perpendicular to the longitudinal direction of the aforementioned gap-shaped apertures.

5. Slit-lens arrangement according to one of claims 1-4, **characterised in that**
- the aforementioned cylinder lenses (4, 5) are electrostatic lenses and the aforementioned quadrupole lenses (6, 7) are electrostatic or magnetic lenses.

6. Slit-lens arrangement according to claim 5, **characterised in that**,
- with magnetic quadrupoles (6, 7), the quadrupole field can be generated from an aperture in a material of high magnetic permeability,
- at the edges of which current-carrying conductors extend parallel to the optical axis of the combined lens,
- the current flow in the conductors being parallel to the opposite edges of the aperture and contrary to the edges perpendicular thereto.

7. Slit-lens arrangement according to claim 6, **characterised in that**
- a magnetic dipole field can be superimposed on the quadrupole field.

8. Slit-lens arrangement according to claim 5, **characterised in that**
- at least one electrode in each case of the cylinder lenses, preferably in each case the inner lens (4b, 5b), in the longitudinal direction of the gap-shaped aperture, is made of segments that are electrically insulated from one another (comb electrodes),
- and different potentials can be applied to the segments.

9. Slit-lens arrangement according to claim 8, **characterised in that**,
- by application of appropriate potentials to the segments, an electrostatic quadrupole lens can be produced.

10. Slit-lens arrangement according to claim 8 or 9, **characterised in that**
- the potentials on the individual segments are time dependent
- and migrate successively from one segment to the next.

11. Slit-lens arrangement according to one of claims 1-10, **characterised in that**
- an aperture with preferably elliptical or rectangular form is provided in the diffraction plane (aperture plane) (8).

12. Slit-lens arrangement according to one of claims 1-11, **characterised in that**,
- in the region of the diffraction plane (aperture plane) (8), an electrode is provided, to which a comparatively high electrical potential can be applied.

13. Slit-lens arrangement according to one of claims 1-12, **characterised in that**
- the aforementioned masks (9) are designed as a self-supporting structure.

14. Slit-lens arrangement according to one of claims 1-13, **characterised in that**
- further electrodes of the cylinder lenses and/or electrodes of additional cylinder lenses are designed as comb electrodes.

15. Slit-lens arrangement according to claim 14, **characterised in that**,
- on the aforementioned electrodes, preferably time-dependent quadrupole fields, which can be displaced in a parallel manner, can be generated.

16. Slit-lens arrangement according to one of claims 1-15, **characterised in that**
- higher-order multipole fields, preferably hexapole and octupole fields, can be superimposed on the quadrupole fields.

17. Slit-lens arrangement according to claim 16, **characterised in that**
- the higher-order multipole fields are electrical fields.

18. Slit-lens arrangement according to one of claims 16-17, **characterised in that**
- the optical axis of the hexapole field and of the octupole field can be displaced in a parallel manner.

19. Use of the slit-lens arrangement according to one of the preceding claims, **characterised in that**
- it can be employed in electron beam or ion beam lithography,
- and in particular is used for the production of wafers.

20. Slit-lens arrangement for particle beams according to one of the preceding claims, **characterised in that**
- between the first and second combined lens, two deflection magnets (23, 24) are provided,
- which, with respect to a pole shoe of a magnet,
- in each case have the same shape,
- and are arranged so as to be mirror symmetrical to the plane that contains those centre planes of the cylinder lenses that face in the longitudinal direction of the gap-shaped apertures,
- the time-constant magnetic fields of both magnets (23, 24) being designed such that
- rays entering in parallel into the magnetic fields of the first magnet (23) in the ray-penetration direction of the slit-lens arrangement are focused at that point (27) of the centre axis (25) that lies on the diffraction plane, and leave the second magnet (24) as parallel rays again,
- the optical axis of the image being displaced in both deflection magnets in diametrically opposite directions,
- and the magnitude of the displacements with respect to one another in each case being in a ratio that corresponds to the imaging scale, preferably the reduction scale.

21. Slit-lens arrangement for particle beams, in particular for projection of a mask onto a workpiece,
- comprising a deflection magnet
- and a plurality of quadrupole lenses,
**characterised in that**
- at least two deflection magnets (23, 24) and two groups (21, 22) of quadrupoles, comprising in each case functionally identical elements, are provided,
- the pole shoes of a magnet having in each case the same shape
- and being arranged mirror-symmetrically with respect to a plane,
- the planes of the two magnets (23, 24) lying coplanar to one another and defining the centre plane of the entire system,
- the optical axes of the aforementioned quadrupole lenses lying in the aforementioned centre plane and being aligned parallel to one another,
- the optical axes of the aforementioned quadrupole lenses being displaceable in parallel by means of superimposed dipole fields,
- the beam path through the entire system being approximately telescopic, the magnetic fields of both magnets (23, 24) being designed such that rays entering the magnetic field of the first magnet (23) in the ray passage direction of the slit-lens arrangement being focused on the centre plane of the entire system and leaving the second magnet (24) again as parallel beams,
- the plane which passes through the aforementioned point (27) standing perpendicular to the centre plane defining the diffraction plane (26),
- the aforementioned quadrupole lenses (21, 22) and the deflection magnets (23, 24) being arranged with respect to the aforementioned point (27) such that they lie antisymmetrically to one another and at the same time meet the condition that
- the distance, measured along the (curved) centre axis 25 of the entire system of the functionally identical element of the aforementioned first (21) and second (22) group of four and of the first (23) and second (24) deflection magnet from the diffraction plane (aperture plane) (26) and the construction and/or the fields of the deflection magnet and of the functionally identical elements of the aforementioned groups of four are in the ratio to one another which corresponds to the imaging scale, preferably the reduction scale,
- the magnitude of the displacements from one another being in each case in a ratio that corresponds to the imaging scale, preferably the reduction scale.

22. Slit-lens arrangement for particle beams according to claim 21, **characterised in that** the entire groups (21, 22) of quadrupoles consist of, in each case, four quadrupole lenses.

23. Slit-lens arrangement for particle beams according to claim 21, **characterised in that** the aforementioned quadrupoles are magnetic.

## Revendications

1. Système de lentilles à fentes pour faisceaux de particules, en particulier pour la projection d'un masque sur une pièce usinée, avec une lentille combinée qui est constituée d'une lentille cylindrique et d'une lentille quadripolaire,
- dont les axes optiques s'étendent parallèlement entre eux,
- l'axe optique de la lentille quadripolaire pouvant être déplacé en parallèle par modification de l'excitation électrique,
- qui présentent une ouverture en forme de fente respective entre les cornes polaires ou dans les électrodes, les différentes ouvertures ayant la même orientation spatiale,
- et qui sont positionnées l'une par rapport à l'autre de telle sorte que
- la focalisation de la lentille quadripolaire s'effectue dans la coupe dans laquelle la lentille cylindrique n'est pas focalisante,
- et la défocalisation de la lentille quadripolaire s'effectue dans la coupe dans laquelle la lentille cylindrique est focalisante,
**caractérisé en ce que**
- il est prévu au moins deux lentilles combinées (1, 2) l'une à la suite de l'autre, ayant respectivement des éléments fonctionnellement identiques,
- les axes optiques des lentilles combinées (1, 2) pouvant être déplacés l'un par rapport à l'autre,
- les points de pénétration des axes à travers le plan d'objet et le plan d'image définissent les centres du champ d'objet et du champ d'image qui sont reproduits l'un sur l'autre,
- et la double déviation de l'axe optique s'effectue par le champ dipolaire induit des lentilles quadripolaires déplacées,
- le trajet des rayons à travers la totalité du système est approximativement télescopique,
- le plan de diffraction (plan d'ouverture) (8) de la totalité du système se situe entre les deux lentilles combinées (1, 2) et définit sur l'axe médian un point (11) par rapport auquel
- les lentilles combinées (1, 2) sont disposées de telle sorte qu'elles sont mutuellement antisymétriques et qu'elles remplissent en même temps la condition que
- la distance de la première et de la deuxième lentille combinée par rapport au plan de diffraction (plan d'ouverture) (8) et la structure et/ou les champs des éléments fonctionnellement identiques des lentilles combinées se trouvent respectivement dans un rapport mutuel qui correspond approximativement à l'échelle de reproduction, de préférence à l'échelle de réduction,
- les déplacements de l'axe optique de la lentille quadripolaire (6, 7) des deux lentilles combinées (1, 2) s'effectuent dans des directions diamétralement opposées,
- les ampleurs des déplacements se trouvant respectivement dans un rapport mutuel qui correspond à l'échelle de reproduction, de préférence à l'échelle de réduction.

2. Système de lentilles à fentes selon la revendication 1, **caractérisé en ce que** le déplacement des axes optiques des lentilles quadripolaires (6, 7) s'effectue dans la direction de l'axe longitudinal des ouvertures en forme de fentes.

3. Système de lentilles à fentes selon la revendication 1 ou 2, **caractérisé en ce que**
- la pièce usinée (10) peut être déplacée perpendiculairement à l'axe médian (3) de la totalité du système et perpendiculairement à l'axe longitudinal des ouvertures en forme de fentes,
- le déplacement de la pièce usinée (10) s'effectue à vitesse constante v₁,
- le déplacement des axes optiques des lentilles quadripolaires précitées (6, 7) est constitué d'un mouvement aller et d'un mouvement de retour,
- sachant que, pendant le mouvement de retour, le champ d'image reproduit sur la pièce usinée (10) se déplace à vitesse constante v₂ sur la pièce,
- et on a pour le rapport des vitesses la relation « v₁/v₂ approximativement égal à d/b »,
- où d est le diamètre du champ d'image et b la largeur de la pièce usinée (10) transversalement à sa direction de déplacement.

4. Système de lentilles à fentes selon l'une des revendications 1 à 3, **caractérisé en ce que**
- le déplacement des axes optiques des lentilles quadripolaires (6, 7) précitées s'écarte de la direction longitudinale des ouvertures précitées en forme de fentes,
- et/ou le déplacement de la pièce usinée (10) s'écarte de la perpendiculaire à la direction longitudinale des ouvertures précitées en forme de fentes, de préférence d'un petit angle.

5. Système de lentilles à fentes selon l'une des revendications 1 à 4, **caractérisé en ce que** les lentilles cylindriques précitées (4, 5) sont des lentilles électrostatiques et les lentilles quadripolaires précitées (6, 7) sont des lentilles électrostatiques ou magnétiques.

6. Système de lentilles à fentes selon la revendication 5, **caractérisé en ce que**, dans le cas de lentilles quadripolaires magnétiques (6, 7), le champ quadripolaire peut être produit par une ouverture dans un matériau de perméabilité magnétique élevée,
- ouverture sur les bords de laquelle des conducteurs parcourus par le courant électrique s'étendent parallèlement à l'axe optique de la lentille combinée,
- le flux de courant dans les conducteurs étant orienté en parallèle sur des bords opposés de l'ouverture, et en sens contraires sur les bords perpendiculaires aux précédents,

7. Système de lentilles à fentes selon la revendication 6, **caractérisé en ce qu'**un champ magnétique dipolaire peut être superposé au champ quadripolaire.

8. Système de lentilles à fentes selon la revendication 5, **caractérisé en ce que**
- au moins une électrode respective des lentilles cylindriques précitées, de préférence l'électrode intérieure respective (4b, 5b), est constituée de segments isolés électriquement les uns des autres dans la direction longitudinale de l'ouverture en forme de fente (électrode en peigne),
- et des potentiels différents peuvent être appliqués aux segments.

9. Système de lentilles à fentes selon la revendication 8, **caractérisé en ce qu'**on peut produire une lentille quadripolaire électrostatique en appliquant aux segments des potentiels correspondants.

10. Système de lentilles à fentes selon la revendication 8 ou 9, **caractérisé en ce que**
- les potentiels sur les segments individuels sont fonction du temps,
- et ils migrent successivement d'un segment au segment suivant.

11. Système de lentilles à fentes selon l'une des revendications 1 à 10, **caractérisé en ce qu'**un diaphragme ayant de préférence une forme elliptique ou rectangulaire est prévu dans le plan de diffraction (plan d'ouverture) (8).

12. Système de lentilles à fentes selon l'une des revendications 1 à 11, **caractérisé en ce qu'**une électrode à laquelle on peut appliquer un potentiel électrique relativement élevé est prévue dans la région du plan de diffraction (plan d'ouverture) (8).

13. Système de lentilles à fentes selon l'une des revendications 1 à 12, **caractérisé en ce que** les masques précités (9) sont conçus sous la forme d'une structure autoporteuse.

14. Système de lentilles à fentes selon l'une des revendications 1 à 13, **caractérisé en ce que** d'autres électrodes des lentilles cylindriques et/ou des électrodes de lentilles cylindriques supplémentaires sont réalisées sous forme d'électrode en peigne.

15. Système de lentilles à fentes selon la revendication 14, **caractérisé en ce que** des champs quadripolaires, de préférence fonction du temps et pouvant être déplacés en parallèle, peuvent être produits sur les électrodes précitées.

16. Système de lentilles à fentes selon l'une des revendications 1 à 15, **caractérisé en ce que** des champs multipolaires d'ordre supérieur, de préférence des champs hexapolaires ou octopolaires, peuvent être superposés aux champs quadripolaires.

17. Système de lentilles à fentes selon la revendication 16, **caractérisé en ce que** les champs multipolaires d'ordre supérieur sont des champs électriques.

18. Système de lentilles à fentes selon la revendication 16 ou 17, **caractérisé en ce que** l'axe optique du champ hexapolaire et du champ octopolaire peut être déplacé en parallèle.

19. Utilisation du système de lentilles à fentes selon l'une des revendications précédentes, **caractérisée en ce que**
- il est employé en lithographie électronique ou ionique,
- et est notamment utilisé pour la fabrication de tranches.

20. Système de lentilles à fentes pour faisceaux de particules selon l'une des revendications précédentes, **caractérisé en ce que**
- deux aimants déflecteurs (23, 24) sont prévus entre la première et la deuxième lentille combinée,
- les cornes polaires associées à un aimant
- présentent respectivement la même forme,
- et sont disposées symétriquement par rapport au plan qui contient les plans médians des lentilles cylindriques qui sont dirigés dans la direction longitudinale des ouvertures en forme de fentes,
- les champs magnétiques, constants dans le temps, des deux aimants (23, 24) sont conçus de telle sorte que des rayons qui pénètrent en parallèle dans le champ magnétique du premier aimant (23) - dans la direction de passage des rayons du système de lentilles à fentes - sont focalisés au point (27) de l'axe médian (25) qui se trouve sur le plan de diffraction, et quittent le deuxième aimant (24) à nouveau sous forme de rayons parallèles,
- l'axe optique de l'image se déplaçant dans des directions diamétralement opposées dans les deux aimants déflecteurs,
- et les ampleurs des déplacements se trouvant respectivement dans un rapport mutuel qui correspond à l'échelle de reproduction, de préférence à l'échelle de réduction.

21. Système de lentilles à fentes pour faisceaux de particules, en particulier pour la projection d'un masque sur une pièce usinée, avec un aimant déflecteur et avec plusieurs lentilles quadripolaires,
**caractérisé en ce que**
- il est prévu au moins deux aimants déflecteurs (23, 24) et deux groupes (21, 22) de quadripôles ayant respectivement des éléments fonctionnellement identiques,
- les cornes polaires associées à un aimant présentent respectivement la même forme et sont disposées symétriquement par rapport à un plan,
- les plans précités des deux aimants (23, 24) sont coplanaires et définissent le plan médian de la totalité du système,
- les axes optiques des lentilles quadripolaires précitées se situent dans le plan médian précité et sont orientés parallèlement entre eux,
- les axes optiques des lentilles quadripolaires précitées peuvent être déplacés en parallèle par des champs dipolaires superposés,
- le trajet des rayons à travers la totalité du système est approximativement télescopique,
- les champs magnétiques, constants dans le temps, des deux aimants (23, 24) sont conçus de telle sorte que des rayons qui pénètrent en parallèle dans le champ magnétique du premier aimant (23) - dans la direction de passage des rayons du système de lentilles à fentes - sont focalisés en un point (27) sur le plan médian de la totalité du système, et quittent le deuxième aimant (24) à nouveau sous forme de rayons parallèles,
- le plan qui passe par le point précité (27) et est perpendiculaire au plan médian définit le plan de diffraction (26),
- les lentilles quadripolaires précitées (21, 22) et les aimants déflecteurs (23, 24) sont disposés, par rapport au point précité (27), de telle sorte qu'ils sont mutuellement antisymétriques et qu'ils remplissent en même temps la condition que
- la distance, mesurée le long de l'axe médian (courbe) (25) de la totalité du système, des éléments fonctionnellement identiques du premier (21) et du deuxième (22) groupe de quatre précité et du premier (23) et du deuxième (24) aimant déflecteur par rapport au plan de diffraction (plan d'ouverture) (26) et la structure et/ou les champs des aimants déflecteurs et des éléments fonctionnellement identiques des groupes de quatre précités se trouvent respectivement dans un rapport mutuel qui correspond approximativement à l'échelle de reproduction, de préférence à l'échelle de réduction,
- sachant que les ampleurs des déplacements se trouvent respectivement dans un rapport mutuel qui correspond à l'échelle de reproduction, de préférence à l'échelle de réduction.

22. Système de lentilles à fentes pour faisceaux de particules selon la revendication 21, **caractérisé en ce que** les groupes (21, 22) de quadripôles sont respectivement constitués en totalité de quatre lentilles quadripolaires.

23. Système de lentilles à fentes pour faisceaux de particules selon la revendication 21, **caractérisé en ce que** les lentilles quadripolaires précitées sont magnétiques.
